# EUROPEAN PATENT SPECIFICATION

(11) **EP 4 092 767 B1**
(45) Date of publication and mention of the grant of the patent: **19.08.2026**
(21) Application number: 21741784.9
(22) Date of filing: 14.01.2021
(51) Int. Cl.: H02N 11/00, H10N 10/13, H10N 10/17

(54) **THERMOELECTRIC CONVERSION STRUCTURE**
THERMOELEKTRISCHE UMWANDLUNGSSTRUKTUR
STRUCTURE DE CONVERSION THERMOÉLECTRIQUE

(30) Priority: 14.01.2020 JP 2020003755
(43) Date of publication of application: 23.11.2022
(73) Proprietor: Asahi Rubber Inc., Saitama-shi, Saitama 330-0801 (JP)
(72) Inventor: YAMAGUCHI, Kazuaki, Saitama-shi, Saitama 330-0801 (JP); TOYOSHIMA, Syuhei, Saitama-shi, Saitama 330-0801 (JP); NAKAMURA, Yuki, Tokyo 103-0027 (JP); UEKI, Yasuro, Tokyo 103-0027 (JP)
(74) Representative: dompatent
(86) International application number: PCT/JP2021/001084
(87) International publication number: WO 2021/145386

(56) References cited:
- EP-A1- 3 244 460
- WO-A1-2016/111359
- JP-A- 2009 302 168
- JP-A- 2014 229 849

## Description

### Technical Field

The present invention relates to a thermoelectric conversion structure which includes a thermoelectric conversion element.

### Background Art

In order to effectively utilize heat, a thermoelectric conversion structure, which includes a thermoelectric conversion element of the Seebeck effect and the Peltier effect or the like, is used. For example, Patent Document 1 discloses a thermoelectric conversion system that includes: a thermoelectric conversion element in which a plurality of p-type and n-type semiconductor elements are alternately and electrically connected in series through metal electrodes; and a metal heat exchanger which is in indirect contact with the thermoelectric conversion element, and in the thermoelectric conversion system, an insulating layer formed with a composite film of resin and inorganic powder is integrally adhered to the thermoelectric conversion element or the metal heat exchanger, and the thermoelectric conversion element and the metal heat exchanger are joined together through a thermally conductive grease with the insulating layer arranged therebetween. Furthermore, EP 3244460 A1 discloses a flexible Peltier device having a single or plural Peltier element which is disposed on one surface side of a heat-emitting sheet having flexibility made from heat-conductive rubber containing a heat conductive filler.

### [Prior Art Document]

### [Patent Document]

[Patent Document 1] JPH11-340523 A

### Summary of Invention

### Problem to be Solved by the Invention

In the thermoelectric conversion structure disclosed in Patent Document 1, the thermally conductive grease layer is formed on the joint surface of constituent members in order to enhance thermal conductivity between the constituent members. However, as the thermoelectric conversion structure of Patent Document 1, the uniform thermally conductive grease layer is formed while air bubbles are prevented from being mixed into the joint surface of the constituent members, and this can also reduce the productivity of the thermoelectric conversion structure. In recent years, an attempt has been made to detachably attach, to an article or part of a human body, a thermoelectric conversion module in which a thermoelectric conversion element is sandwiched between insulators to heat or cool the article or the part of the human body. As described above, when the thermoelectric conversion module is detachably attached to the article or the part of the human body, a thermally conductive grease layer cannot be formed for the purpose of enhancing heat transfer characteristics therebetween, with the result that the heat transfer characteristics therebetween is lowered.

The present invention is made in order to solve the problem described above, and an object of the present invention is to provide a thermoelectric conversion structure in which a thermoelectric conversion module having a thermoelectric conversion element sandwiched between thermally conductive members and heat transfer target members such as a heat dissipation member and a heat absorption member are removable and which can enhance heat transfer characteristics therebetween.

### Means to Solve the Above Problems

A thermoelectric conversion structure according to the present invention is provided to achieve the object described above. There is provided a thermoelectric conversion structure in which a thermoelectric conversion module integrated by joining surfaces of a thermoelectric conversion element on a high temperature side and a low temperature side to thermally conductive elastomer sheets containing a thermally conductive filler is arranged between heat transfer target members that transfer heat to the thermoelectric conversion element, wherein surfaces of the thermally conductive elastomer sheets and corresponding surfaces of the heat transfer target members are in direct intimate contact with each other and are removable from each other, a thickness of each of the thermally conductive elastomer sheets is 0.3-0.5mm, a hardness of the thermally conductive elastomer sheets measured with a type A durometer according to JIS K 6253 : 2012 at standard testing temperature thereof according to JIS K 6250 6.1: 2006 is 70/s-90/s, and elastomer components of the thermally conductive elastomer sheets are resin material selected from the group consisting of polyimide, PEEK and PSS, or rubber material selected from the group consisting of silicone rubber, ethylene-propylene-diene copolymer rubber and urethane rubber.

The hardness of the thermally conductive elastomer sheet measured with a type A durometer according to JIS K 6253 is 70/s-90/s and thus intimate contact between the thermally conductive elastomer sheets and the heat transfer target members can be enhanced, and the countermeasure of thermal deformation such as thermal expansion of constituent members can be further enhanced.

The thermal conductivity of the thermally conductive elastomer sheet may be 1.0 W/(m·K) or more, and thus it is possible to enhance heat exchange characteristics between the thermoelectric conversion element and the heat transfer target members.

The thermoelectric conversion element and the thermally conductive elastomer sheets may be integrally joined by a direct covalent bond between active groups in the surfaces of the thermoelectric conversion element and the thermally conductive elastomer sheets or an indirect covalent bond therebetween through a molecular adhesive, and thus even if the constituent members of the thermoelectric conversion structure are thermally deformed by thermal expansion or the like, it is possible to prevent separation between the thermoelectric conversion element and the thermally conductive elastomer sheets.

### Effects of the Invention

Since in the thermoelectric conversion structure according to the present invention, the thermoelectric conversion element is arranged between heat transfer target members through thermally conductive elastomer sheets, even if the constituent members are thermally deformed by thermal expansion or the like, the thermal deformation can be absorbed by the thermally conductive elastomer sheets. Moreover, in the thermoelectric conversion module of the thermoelectric conversion structure according to the present invention, the surfaces of the thermoelectric conversion element on a high temperature side and the low temperature side are integrally joined to the thermally conductive elastomer sheets containing the thermally conductive filler, and the surfaces of the thermally conductive elastomer sheets of the thermoelectric conversion module are in direct intimate contact with the corresponding surfaces of the heat transfer target members, with the result that it is possible to provide satisfactory heat transfer characteristics without the formation of a thermally conductive grease layer on the joint surfaces. As described above, the thermoelectric conversion module and the heat transfer target members can be in intimate contact with each other without the formation of the thermally conductive grease layer, and thus the productivity of the thermoelectric conversion structure can be enhanced and the thermoelectric conversion structure can also be used for an application for removing the thermoelectric conversion module from the heat transfer target members and a human body.

### Brief Description of Drawings

[Fig. 1]

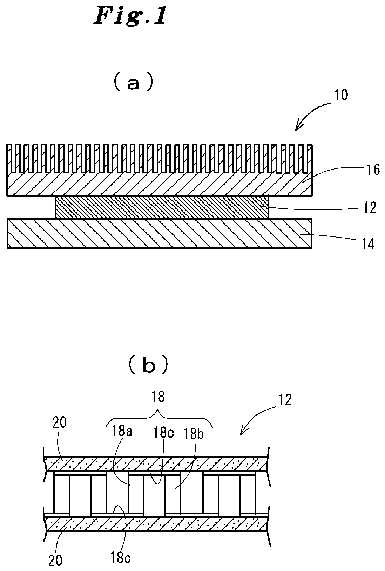

   Fig. 1 is a cross-sectional view of a thermoelectric conversion structure to which the present invention is applied and a partial cross-sectional view of a thermoelectric conversion module.
[Fig. 2]

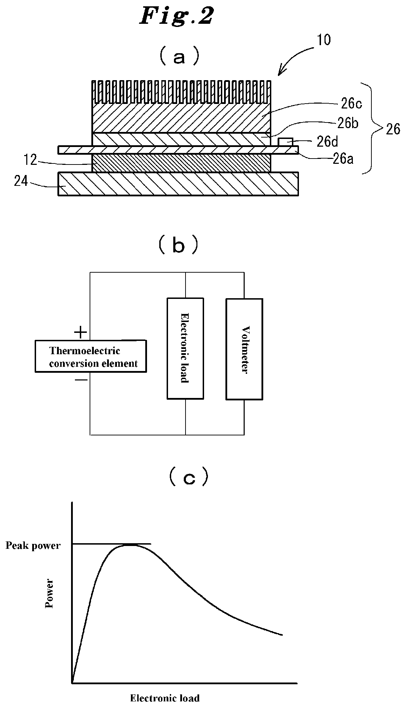

   Fig. 2 is a cross-sectional view of a thermoelectric conversion structure for the Seebeck effect to which the present invention is applied, a power measurement circuit diagram and an illustrative diagram of peak power.
[Fig. 3]

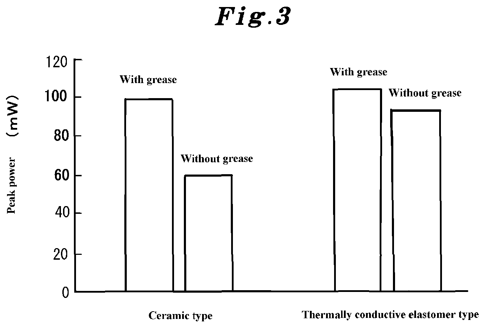

   Fig. 3 is a graph showing the results of measurements of the peak power of each of the thermoelectric conversion structures for the Seebeck effect.
[Fig. 4]

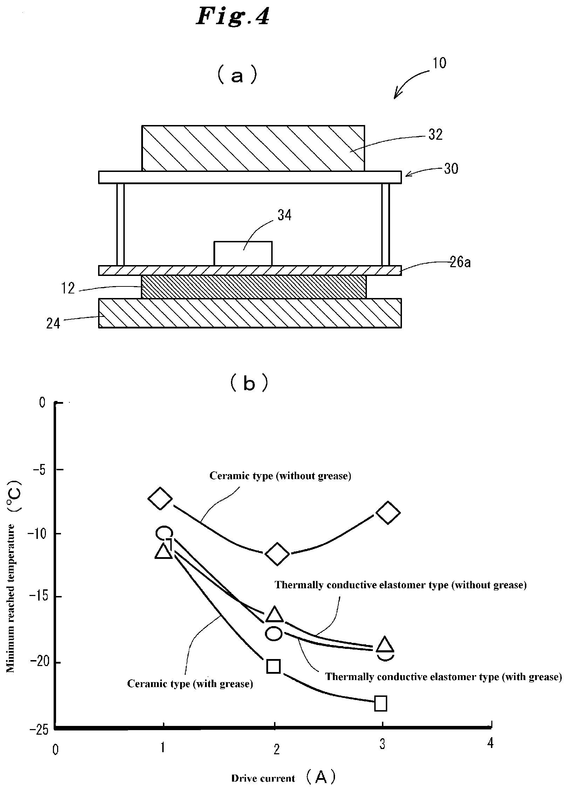

   Fig. 4 is a cross-sectional view of a thermoelectric conversion structure for the Peltier effect to which the present invention is applied and a graph showing a relationship between the minimum reached temperature and a drive current.
[Fig. 5]

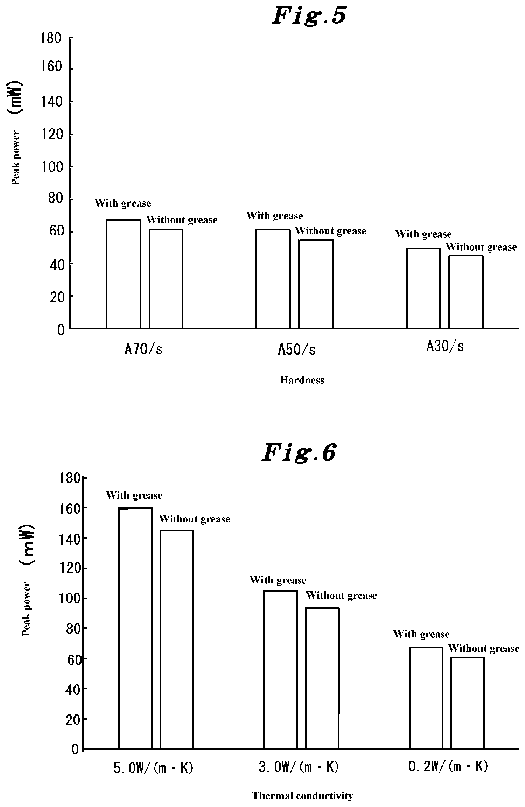

   Fig. 5 is a graph showing the results of measurements of the peak power in differences in the hardness of elastomer sheets of the thermoelectric conversion structures for the Seebeck effect.
[Fig. 6]
   Fig. 6 is a graph showing the results of measurements of the peak power in differences in the thermal conductivity of the thermally conductive elastomer sheets of the thermoelectric conversion structures for the Seebeck effect.

### Embodiments to Implement the Invention

Although the present invention will be described in detail below, the scope of the present invention is not limited to the following description.

An example of a thermoelectric conversion structure according to the present invention is shown in Fig. 1. Fig. 1(a) is a cross-sectional view of the thermoelectric conversion structure 10, and Fig. 1(b) is a partial cross-sectional view of a thermoelectric conversion module 12. In the thermoelectric conversion structure 10, the thermoelectric conversion module 12 is arranged between heat transfer target members 14 and 16 which transfer heat to the thermoelectric conversion module 12 or to which heat is transferred. The thermoelectric conversion element 18 of the thermoelectric conversion module 12 is formed by coupling, as shown in Fig. 1(b), an n-type semiconductor element 18a and a p-type semiconductor element 18b in series with conductive patterns 18c. The surfaces of the thermoelectric conversion element 18 on a high temperature side and a low temperature side are integrally joined to thermally conductive elastomer sheets 20.

The thermally conductive elastomer sheet 20 is formed of a thermally conductive elastomer containing a thermally conductive filler. Examples of the thermally conductive filler include magnesium oxide (MgO), aluminum oxide (Al₂O₃), aluminum nitride (AlN), boron nitride (BN), silicon nitride (Si₃N₄), diamond, carbon, fullerene, carbon graphite and combinations of two or more types thereof. The amount of thermally conductive filler mixed is preferably 50 to 95% by weight (and more preferably 65 to 90% by weight).

The components of the thermally conductive elastomer are formed of an elastomer composition including at least a resin material or a rubber material. Examples of the resin material include polyimide, PEEK, PSS and the like. Examples of the rubber material include silicone rubber, ethylene-propylene-diene copolymer rubber (EPDM), urethane rubber, fluororubber and the like. Among these materials, in terms of enhancing flexibility, tackiness and a following capability, silicone rubber is preferable, and in terms of lowering gas permeability and enhancing water resistance, EPDM is preferable.

The main component of the silicone rubber serving as the rubber material is peroxide cross-linking silicone rubber, additional cross-linking silicone rubber, condensation cross-linking silicone rubber or a blend of one of these silicone rubbers and olefin rubber. A heat dissipation rubber insulator formed of silicone rubber is used, and thus high flexibility is provided in a wide temperature range of, for example, - 40°C to 200°C, flexural fatigue resistance and the following capability can be enhanced and expansion caused by a heat shock can be prevented. These silicone rubbers have a number average molecular weight of 10000 to 1 million.

Although the peroxide cross-linking silicone rubber is not particularly limited as long as the peroxide cross-linking silicone rubber is synthesized with a silicone raw material compound capable of being cross-linking by a peroxide cross-linking agent, and specific examples thereof include polydimethylsiloxane, vinylmethylsiloxane/polydimethylsiloxane copolymer, vinyl-terminated polydimethylsiloxane, vinyl-terminated diphenylsiloxane/polydimethylsiloxane copolymer, vinyl-terminated diethylsiloxane/polydimethylsiloxane copolymer, vinyl-terminated trifluoropropylmethylsiloxane/polydimethylsiloxane copolymer, vinyl-terminated polyphenylmethylsiloxane, vinylmethylsiloxane/dimethylsiloxane copolymer, trimethylsiloxane group-terminated dimethylsiloxane/vinylmethylsiloxane copolymer, trimethylsiloxane group-terminated dimethylsiloxane/vinylmethylsiloxane/diphenylsiloxane copolymer, trimethylsiloxane group-terminated dimethylsiloxane/vinylmethylsiloxane/ ditrifluoropropylmethylsiloxane copolymer, trimethylsiloxane group-terminated polyvinyl methylsiloxane, metacryloxypropyl group-terminated polydimethylsiloxane, acryloxypropyl group-terminated polydimethylsiloxane, (metacryloxypropyl) methylsiloxane/dimethylsiloxane copolymer, and (acryloxypropyl) methylsiloxane/dimethylsiloxane copolymer.

Examples of the peroxide cross-linking agent which is made to coexist therewith include ketone peroxides, diacyl peroxides, hydroperoxides, dialkyl peroxides, peroxyketals, alkyl peresters and percarbonates, and specific examples thereof include ketone peroxide, peroxyketal, hydroperoxide, dialkyl peroxide, peroxycarbonate, peroxyester, benzoyl peroxide, dicumyl peroxide, dibenzoyl peroxide, t-butylhydroperoxide, di-t-butylhydroperoxide, di(dicyclobenzoyl) peroxide, 2,5-dimethyl-2,5 bis(t-butylperoxy) hexane, 2,5-dimethyl-2,5 bis(t-butylperoxy) hexine, benzophenone, Michler's ketone, dimethylaminobenzoic acid ethyl ester and benzoin ethyl ether.

Although the amount of the peroxide cross-linking agent used is selected as necessary according to the type of silicone rubber obtained, the properties of the heat dissipation rubber insulator formed of the silicone rubber and the properties of a silane coupling agent used as necessary, the amount of the peroxide cross-linking agent used is 0.01 to 10 parts by mass, and preferably 0.1 to 2 parts by mass with respect to 100 parts by mass of silicone rubber. If the amount of peroxide cross-linking agent used is less than the range described above, the degree of cross-linking is excessively low, and thus the peroxide cross-linking agent cannot be used as silicone rubber. On the other hand, if the amount of peroxide cross-linking agent used is larger than the range described above, the degree of cross-linking is excessively high, and thus the elasticity of the silicone rubber is reduced.

The additional cross-linking silicone rubber is obtained from: a composition of vinyl group-containing polysiloxane such as vinyl methyl siloxane/polydimethyl siloxane copolymer synthesized in the presence of a Pt catalyst, vinyl-terminated polydimethyl siloxane, vinyl-terminated diphenyl siloxane/polydimethyl siloxane copolymer, vinyl-terminated diethyl siloxane/polydimethyl siloxane copolymer, viny-terminated trifluoropropyl methyl siloxane/polydimethylsiloxane copolymer, vinyl-terminated polyphenylmethylsiloxane, vinylmethylsiloxane/dimethylsiloxane copolymer, trimethylsiloxane group-terminated dimethylsiloxane/vinylmethylsiloxane/diphenylsiloxane copolymer, trimethylsiloxane group-terminated dimethylsiloxane/vinylmethylsiloxane/ditrifluoropropylmethyl siloxane copolymer or trimethylsiloxane group-terminated polyvinylmethylsiloxane and of H group-containing polysiloxane exemplified by H-terminated polysiloxane, methyl-H-siloxane/dimethylsiloxane copolymer, polymethyl-H-siloxane, polyethyl-H-siloxane, H-terminated polyphenyl (dimethyl-H-siloxy) siloxane, methyl-H-siloxane/phenylmethylsiloxane copolymer or methyl-H-siloxane/octylmethylsiloxane copolymer; or a composition of amino group-containing polysiloxane exemplified by aminopropyl-terminated polydimethylsiloxane, aminopropylmethylsiloxane/dimethylsiloxane copolymer, aminoethylaminoisobutylmethylsiloxane/dimethylsiloxane copolymer, aminoethylaminopropylmethoxysiloxane/dimethylsiloxane copolymer or dimethylamino-terminated polydimethylsiloxane, and of epoxy group-containing polysiloxane exemplified by epoxypropyl-terminated polydimethylsiloxane or (epoxycyclohexylethyl) methylsiloxane/dimethylsiloxane copolymer, acid anhydride group-containing polysiloxane exemplified by succinic acid anhydride-terminated polydimethylsiloxane and an isocyanate group-containing compound such as toluyl diisocyanate or 1,6-hexamethylene diisocyanate.

When the thermally conductive elastomer is produced from these compositions, the compositions and the thermally conductive filler are kneaded and are thereafter heated at a predetermined temperature for a predetermined time and thus the thermally conductive elastomer can be obtained. Although the production conditions such as the heating temperature and the heating time differ depending on the type and characteristics of an addition reaction, and thus they cannot be uniquely determined, in general, the heating is performed at 0 to 200°C for one minute to 24 hours. **In** this way, the additional cross-linking silicone rubber with which the thermally conductive filler is mixed and which has thermal conductivity is obtained. When the physical properties of the silicone rubber are excellent, a reaction time is longer under low temperature processing conditions. When quick productivity is required as compared with the physical properties, the production is performed under the processing conditions of high temperature and short time. When the processing needs to be performed within a certain time depending on a production process and a work environment, the processing temperature is set to a relatively high temperature within the range described above according to a desired processing time, and thus the production is performed.

The condensation cross-linking silicone rubber is obtained from: a composition of a single condensing component selected from silanol group-terminated polysiloxane exemplified by silanol-terminated polydimethylsiloxane synthesized in the presence of a tin-based catalyst, silanol-terminated polydiphenylsiloxane, silanol-terminated polytrifluoromethylsiloxane or silanol-terminated diphenylsiloxane/dimethylsiloxane copolymer; a composition of the silanol group-terminated polysiloxane described above and a cross-linking agent exemplified by tetraacetoxysilane, triacetoxymethylsilane, di-t-butoxydiacetoxysilane, vinyltriacetoxysilane, tetraethoxysilane, trienoxymethylsilane, bis(triethoxysilyl) ethane, tetra-n-propoxysilane, vinyltrimethoxy silane, methyltris (methylethylketoxim) silane, vinyltris (methylethylketoximino) silane, vinyltriisopropenoxysilane, triacetoxymethylsilane, tri(ethylmethyl) oximemethylsilane, bis(N-methylbenzoamido) ethoxymethylsilane, tris(cyclohexylamino) methylsilane, triacetamide methylsilane or tridimethylaminomethylsilane; or a composition of the silanol group-terminated polysiloxane described above and terminal block polysiloxane exemplified by chlor-terminated polydimethylsiloxane, diacetoxymethyl-terminated polydimethylsiloxane or terminal polysiloxane.

When the condensation cross-linking silicone rubber with which the thermally conductive filler is mixed and which has thermal conductivity is produced from these compositions, the compositions and the thermally conductive filler are kneaded and are thereafter heated at a predetermined temperature for a predetermined time and thus the condensation cross-linking silicone rubber can be obtained. Although the production conditions such as the heating temperature and the heating time differ depending on the type and characteristics of a condensation reaction, and thus they cannot be uniquely determined, in general, the heating is performed at 0 to 100°C for 10 minutes to 24 hours. When the physical properties of the silicone rubber are excellent, a reaction time is longer under low temperature processing conditions. When quick productivity is required as compared with the physical properties, the production is performed under the processing conditions of high temperature and short time. When the processing needs to be performed within a certain time depending on the production process and the work environment, the processing temperature is set to a relatively high temperature within the range described above according to a desired processing time, and thus the production is performed.

The thermally conductive elastomer may be a blend of silicone rubber and non-silicone rubber. Examples of the non-silicone rubber include olefin rubber such as 4-cis butadiene rubber, isoprene rubber, styrene-butadiene copolymer rubber, polybutene rubber, polyisobutylene rubber, ethylene-propylene rubber, ethylene-propylene-diene rubber, chlorinated ethylene-propylene rubber, chlorinated butyl rubber, natural rubber, 1,4-cis butadiene rubber, isoprene rubber, polychloroprene, styrene-butadiene copolymer rubber, hydrogenated styrene-butadiene copolymer rubber, acrylic nitrile-butadiene copolymer rubber, hydrogenated acrylic nitrile-butadiene copolymer rubber, polybutene rubber, polyisobutylene rubber, ethylene oxide-epichlorohydrin copolymer rubber, chlorinated polyethylene rubber, chlorsulphonized polyethylene rubber, alkylated chlorsulphonized polyethylene rubber, chloroprene rubber, chlorinated acrylic rubber, brominated acrylic rubber, fluororubber, epichlorohydrin and copolymer rubber thereof, brominated butyl rubber, tetrafluoroethylene, hexafluoropropyrene, vinylidene fluoride and homopolymer rubber such as tetrafluoroloethylene, binary and ternary copolymer rubbers thereof, ethylene-tetrafluoroethylene copolymer rubber, propylene-tetrafluoroethylene copolymer rubber, ethylene acrylic rubber, epoxy rubber, urethane rubber and a cross-linking mixture of raw rubber-like materials exemplified by a linear polymer such as double-ended unsaturated group elastomer. These may be used singly or a plurality of types may be mixed to be used.

Examples of other rubber materials include ethylene-propylene-diene copolymer rubber, urethane rubber and fluororubber.

In the thermally conductive elastomer sheet 20 formed of the thermally conductive elastomer as described above, when the thickness thereof is excessively thin, it is more likely that it is difficult to perform the processing whereas when the thickness is excessively thick, it is more likely that the thermal conductivity is lowered, with the result that the thickness is 0.5 to 0.3 mm. In the thermally conductive elastomer sheet 20 having a thickness less than 0.1 mm, there is a tendency that the strength thereof is insufficient and thus it is difficult to perform the processing whereas in the thermally conductive elastomer sheet 20 having a thickness exceeding 1.0 mm, the thermal conductivity tends to be lowered. The thermal conductivity of the thermally conductive elastomer sheet 20 is preferably 1.0 W/(m·K) or more (more preferably 10 to 3 W/(m·K)) When the thermally conductive elastomer sheet 20 whose thermal conductivity is less than 1.0 W/(m·K) is used, the heat transfer property of the thermally conductive elastomer sheet 20 tends to be lowered. Furthermore, the hardness of the thermally conductive elastomer sheet 20 measured with a type A durometer according to JIS K 6253 is 70/s - 90/s. In the thermally conductive elastomer sheet 20 having a low hardness as described above, the degree of intimate contact with the corresponding surfaces of the heat transfer target members 14 and 16 can be enhanced. Even when one of the heat transfer target members 14 and 16 has minute recesses and projections, the heat transfer target members 14 and 16 can be in intimate contact with the thermally conductive elastomer sheet 20.

The thermoelectric conversion element 18 is formed by using the conductive patterns 18c to couple two different types of thermoelectric conversion element materials such as metals or semiconductors. Although the thermoelectric conversion element material is not particularly limited, examples thereof include clathrate compounds, CNTs such as bismuth-tellurium type, lead-tellurium type, antimony-tellurium type, iron-aluminum type, silicon-germanium type, silicon system and germanium type, the thermoelectric conversion element material is selected as necessary according to a usage temperature range and a connection form. Although the conductive pattern is not particularly limited, examples thereof include gold, silver, copper, aluminum and various types of alloys, conductive inks of silver, conductive inks of carbon and the like, the conductive pattern is selected as necessary according to the usage temperature range and the connection form.

The thermoelectric conversion element 18 is formed by coupling, as shown in Fig. 1(b), the n-type semiconductor element 18a and the p-type semiconductor element 18b in series with the conductive patterns 18c. In the thermoelectric conversion element 18 as described above, the joint surfaces of the n-type semiconductor element 18a, the p-type semiconductor element 18b thereof (hereinafter referred to as constituent semiconductor elements) and the conductive patterns 18c and the thermally conductive elastomer sheets 20, 20 are securely and integrally joined by chemical bonding and molecular adhesion using a direct covalent bond between active groups included in the surfaces thereof, for example, between reactive active groups such as a hydroxyl group (-OH) and a hydroxysilyl group (-SiOH). The chemical bond as described above is preferably an ether bond caused by dehydration of OH groups.

In the thermally conductive elastomer sheet 20 and the constituent semiconductor elements, on part or the whole of at least any one of the surfaces serving as the joint surfaces, dry treatment such as corona treatment, plasma treatment or ultraviolet irradiation treatment may be performed. Although the ultraviolet irradiation treatment is not limited as long as the ultraviolet irradiation treatment is treatment for irradiating with ultraviolet rays, the ultraviolet irradiation treatment may be general ultraviolet treatment (UV treatment) for irradiating with ultraviolet rays in a wide wavelength range or ultraviolet rays of multiple wavelengths or excimer ultraviolet treatment (excimer UV treatment) for irradiating with excimer ultraviolet rays which can be regarded as a single wavelength. By the dry treatment described above, in addition to active groups such as a hydroxyl group originally included in the surfaces, an active group can be further generated, and the active groups originally included therein and the active group generated by the activation produce, in the surfaces opposite each other, a covalent bond and specifically a strong ether bond caused by dehydration, with the result that the thermally conductive elastomer sheets 20 and the constituent semiconductor elements can be joined chemically, directly and integrally.

The thermally conductive elastomer sheets 20 and the constituent semiconductor elements may be integrally joined by a covalent bond through a molecular adhesive. In molecular adhesive treatment, functional groups in the molecules of the molecular adhesive undergo a chemical reaction of adherends and a covalent bond, and thus the constituent semiconductor elements and the thermally conductive elastomer sheets 20 are directly bonded through a covalent bond caused by the single or multiple molecules of the molecular adhesive. The molecular adhesive is a generic term for bifunctional molecules in which two functional groups undergo a chemical reaction with the constituent semiconductor elements and the thermally conductive elastomer sheets 20 serving as the adherends to form a covalent bond. Specific examples thereof include various types of coupling agents such as a silane coupling agent.

More specifically, examples of the molecular adhesive include: an amino group-containing compound such as triethoxysilylpropylamino-1,3,5-triazine-2,4-dithiol (TES) and aminoethylaminopropyl trimethoxysilane; a triazine compound which has a trialkoxysilylalkylamino group such as a triethoxysilylpropylamino group and a mercapto group or an azido group, and which is represented by chemical formula (I) below: 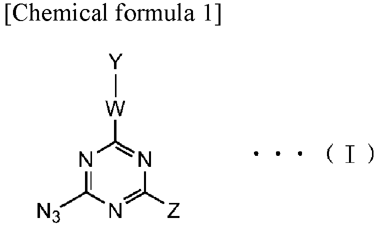 (in the formula (I), W is a spacer group which may be, for example, an alkylene group or an aminoalkylene group optionally having a substituent or may be a direct bond, Y is an OH group or a reactive functional group for generating an OH group by hydrolysis or desorption such as a trialkoxyalkyl group, -Z is -N₃ or -NR¹R² (where R¹ and R² are the same or different and are H, an alkyl group or -R³Si(R⁴)ₘ(OR⁵)₃₋ₘ [R³ and R⁴ are an alkyl group, R⁵ is H or an alkyl group and m is 0 to 2] and the alkylene group, the alkoxy group and the alkyl group are a linear, branched and/or cyclic hydrocarbon group having 1 to 12 carbon atoms and optionally having a substituent); a thiol compound having a trialkoxysilylalkyl group; an epoxy compound having a trialkyloxysilylalkyl group; and a silane coupling agent such as vinyl alkoxysiloxane polymer exemplified by CH₂ = CH-Si (OCH₃)₂-O- [Si (OCH₃)₂-O-]ₙ-Si(OCH₃)₂-CH = CH₂ (n = 1.8-5.7).

Examples of the molecular adhesive include commercially available silane coupling agents serving as alkoxy group-containing and amino group-free silane coupling agents, and specific examples include: vinyl group and alkoxy group-containing silane coupling agents exemplified by vinyl trimethoxysilane (KBM-1003) and vinyl triethoxysilane (KBE-1003); epoxy group and alkoxy group-containing silane coupling agents exemplified by 2-(3,4-epoxycyclohexyl) ethyltrimethoxysilane (KBM-303), 3-glycidoxypropylmethyldimethoxysilane (KBM-402), 3-glycidoxypropyltrimethoxysilane (KBM-403), 3-glycidoxypropylmethyldiethoxysilane (KBE-402) and 3-glycidoxypropyltriethoxysilane (KBE-403); styril group and alkoxy group-containing silane coupling agents exemplified by p-styryltrimethoxysilane (KBM-1403); (meta)acrylic group and alkoxy group-containing silane coupling agents exemplified by 3-methacryloxypropylmethyldimethoxysilane (KBM-502), 3-methacryloxypropyltrimethoxysilane (KBM-503), 3-methacryloxypropylmethyldiethoxysilane (KBE-502), 3-methacryloxypropylmethyldiethoxysilane (KBE-503) and 3-acryloxypropyltrimethoxysilane (KBM-5103); ureido group and alkoxy group-containing silane coupling agents exemplified by 3-ureidopropyltriethoxysilane (KBE-585); mercapto group and alkoxy group-containing silane coupling agents exemplified by 3-mercaptopropylmethyldimethoxysilane (KBM-802) and 3-mercaptopropyltrimethoxysilane (KBM-803); sulfide group and alkoxy group-containing silane coupling agents exemplified by bis(triethoxysilylpropyl) tetrasulfide (KBE-846); isocyanate group and alkoxy group-containing silane coupling agents exemplified by 3-isocyanatopropyltriethoxysilane (KBE-9007) (all the silane coupling agents described above are made by Shin-Etsu Chemical Co., Ltd.; product names); vinyl group and acetoxy-containing silane coupling agents exemplified by vinyl triacetoxysilane (Z-6075); allyl group and alkoxy group-containing silane coupling agents exemplified by allyltrimethoxysilane (Z-6825); alkyl group and alkoxy group-containing silane coupling agents exemplified by methyltrimethoxysilane (Z-6366), dimethyldimethoxysilane (Z-6329), trimethylmethoxysilane (Z-6013), methyltriethoxysilane (Z-6383), methyltriphenoxysilane (Z-6721), ethyltrimethoxysilane (Z-6321), n-propyltrimethoxysilane (Z-6265), diisopropyldimethoxysilane (Z-6258), isobutyltrimethoxysilane (Z-2306), diisobutyldimethoxysilane (Z-6275), isobutyltriethoxysilane (Z-6403), n-hexyltrimethoxysilane (Z-6583), n-hexyltriethoxysilane (Z-6586), cyclohexylmethyldimethoxysilane (Z-6187), n-octyltriethoxysilane (Z-6341) and n-decyltrimethoxysilane (Z-6210); aryl group and alkoxy group-containing silane coupling agents exemplified by phenyltrimethoxysilane (Z-6124); alkyl group and chlorosilane group-containing silane coupling agents exemplified by n-octyldimethylchlorosilane (ACS-8); and silane coupling agents of alkoxy silane exemplified by tetraethoxysilane (Z-6697) (all the silane coupling agents described above are made by Dow Toray Co., Ltd.; product names).

The alkoxy group-containing and amino group-free silane coupling agent may be a hydrosilyl group (SiH group)-containing alkoxysilyl compound such as

(CH₃O)₃SiCH₂CH₂CH₂Si(CH₃)₂OSi(CH₃)₂H,

(C₂H₅O)₃SiCH₂CH₂CH₂Si(CH₃)₂OSi(CH₃)₂H,

(CH₃O)₃SiCH₂CH₂CH₂Si(OCH₃)₂OSi(OCH₃)₃,

(C₂H₅O)₃SiCH₂CH₂CH₂Si(OCH₃)₂OSi(OCH₃)₃,

(C₂H₅O)₃SiCH₂CH₂CH₂Si(CH₃)₂H,

(CH₃O)₃SiCH₂CH₂CH₂Si(CH₃)₂H,

(i-C₃H₇O)₃SiCH₂CH₂CH₂Si(CH₃)₂H,

(n-C₃H₇O)₃SiCH₂CH₂CH₂Si(CH₃)₂OSi(CH₃)₂CH₂CH₂Si(CH₃)₂Si(CH₃)₂H,

(n-C₄H₉O)₃SiCH₂CH₂CH₂Si(CH₃)₂OSi(CH₃)₂H,

(t-C₄H₉O)₃SiCH₂CH₂CH₂Si(CH₃)₂OSi(CH₃)₂H,

(C₂H₅O)₂CH₃SiCH₂CH₂CH₂Si(CH₃)₂OSi(CH₃)₂H,

(CH₃O)₂CH₃SiCH₂CH₂CH₂Si(CH₃)₂OSi(CH₃)₂CH₂CH₂Si(CH₃)₂Si(CH₃)₂H,

CH₃O(CH₃)₂SiCH₂CH₂CH₂Si(CH₃)₂OSi(CH₃)₂H,

(C₂H₅O)₃SiCH₂CH₂CH₂Si(CH₃)₂OSi(CH₃)₂H,

(n-C₃H₇)₃SiCH₂CH₂CH₂Si(CH₃)₂OSi(CH₃)₂H,

(i-C₃H₇O)₃SiCH₂CH₂CH₂Si(CH₃)₂OSi(CH₃)₂H,

(n-C₄H₉)₃SiCH₂CH₂CH₂Si(CH₃)₂OSi(CH₃)₂H,

(t-C₄H₉O)₃SiCH₂CH₂CH₂Si(CH₃)₂OSi(CH₃)₂H,

(C₂H₅O)₃SiCH₂CH₂Si(CH₃)₂OSi(CH₃)₂H,

(C₂H₅O)₃SiCH₂CH₂CH₂CH₂Si(CH₃)₂OSi(CH₃)₂H,

(C₂H₅O)₃SiCH₂CH₂CH₂CH₂CH₂CH₂Si(CH₃)₂OSi(CH₃)₂H,

(C₂H₅O)₃SiCH₂CH₂CH₂CH₂CH₂CH₂CH₂CH₂CH₂CH₂Si(CH₃)₂OSi(CH₃)₂H,

(CH₃O)₃SiCH₂C₆H₄CH₂CH₂Si(CH₃)₂C₆H₄Si(CH₃)₂H,

(CH₃O)₂CH₃SiCH₂C₆H₄CH₂CH₂Si(CH₃)₂C₆H₄Si(CH₃)₂H,

CH₃O(CH₃)₂SiCH₂C₆H₄CH₂CH₂Si(CH₃)₂C₆H₄Si(CH₃)₂H,

(C₂H₅O)₃SiCH₂C₆H₄CH₂CH₂Si(CH₃)₂C₆H₄Si(CH₃)₂H,

(C₂H₅O)₃SiCH₂CH₂CH₂Si(CH₃)₂C₆H₄OC₆H₄Si(CH₃)₂H,

(C₂H₅O)₃SiCH₂CH₂CH₂Si(CH₃)₂C₂H₄Si(CH₃)₂H,

(C₂H₅O)₃SiCH₂CH₂CH₂Si(CH₃)₂O[Si(CH₃)₂O]ₚ₁Si(CH₃)₂H,

C₂H₅O(CH₃)₂SiCH₂CH₂CH₂Si(CH₃)₂O[Si(CH₃)₂O]ₚ₂Si(C₂H₅)₂H,

(C₂H₅O)₂CH₃SiCH₂CH₂CH₂Si(CH₃)₂O[Si(CH₃)₂O]ₚ₃Si(CH₃)₂H,

(CH₃)₃SiOSiH(CH₃)O[SiH(CH₃)O]ₚ₄Si(CH₃)₃,

(CH₃)₃SiO[(C₂H₅OSi(CH₃)CH₂CH₂CH₂)SiCH₃]O[SiH(CH₃)O]ₚ₅Si(CH₃)₃,

(CH₃)₃SiO[(C₂H₅OSiOCH₃CH₂CH₂CH₂)SiCH₃]O[SiH(CH₃)O]ₚ₆Si(CH₃)₃,

(CH₃)₃SiO[(C₂H₅OSi(CH₃)CH₂CH₂CH₂)SiCH₃]O[SiH(CH₃)O]ₚ₇Si(CH₃)₃,

(CH₃)₃SiO[(Si(OC₂H₅)₂CH₂CH₂CH₂)SiCH₃]O[SiH(CH₃)O]ₚ₈Si(CH₃)₃,

(CH₃)₃SiOSi(OC₂H₅)₂O[SiH(CH₃)O]ₚ₉[Si(CH₃)₂O]_{q1}Si(CH₃)₃,

(CH₃)₃SiO[(C₂H₅OSi(CH₃)CH₂CH₂CH₂CH₂CH₂CH₂)Si(CH₃)O][SiH(CH₃)O]ₚ₁₀[Si(C H₃)₂O]_{q2}Si(CH₃)₃,

(CH₃)₃SiO[(Si(OCH₃)₃CH₂CH₂CH₂CH₂CH₂CH₂)Si(CH₃)O][SiH(CH₃)O]ₚ₁₁[Si(CH₃)₂ O]_{q3}Si(CH₃)₃,

(CH₃)₃SiOSi(OC₂H₅)₂O[SiH(C₂H₅)O]ₚ₁₂Si(CH₃)₃,

(CH₃)₃SiO[(Si(OC₂H₅)₂CH₂CH₂CH₂CH₂CH₂CH₂)Si(C₂H₅)]O[SiH(C₂H₅)O]ₚ₁₃Si(CH₃) 3,

(CH₃)₃SiO[(C₂H₅OSi(CH₃)CH₂CH₂CH₂CH₂CH₂CH₂)Si(C₂H₅)]O[SiH(C₂H₅)O]ₚ₁₄Si(C H3)3,

C₂H₅OSi(CH₃)₂CH₂CH₂CH₂CH₂CH₂CH₂(CH₃)₂SiO[HSi(CH₃)₂OSiC₆H₅O]ₚ₁₅Si(CH₃)₂ H,

Si(OCH₃)₃CH₂CH₂CH₂CH₂CH₂CH₂(CH₃)₂SiO[HSi(CH₃)₂OSiC₆H₅O]ₚ₁₆Si(CH₃)₂H,

H(CH₃)₂SiO[(C₂H₅OSi(CH₃)₂CH₂CH₂CH₂)Si(CH₃)O][HSiCH₃O]ₚ₁₇Si(CH₃)₂H,

H(CH₃)₂SiO[(C₂H₅OSi(CH₃)₂CH₂CH₂CH₂CH₂)Si(CH₃)O][HSiCH₃O]ₚ₁₈Si(CH₃)₂H,

H(CH₃)₂SiO[(C₂H₅OSi(CH₃)₂CH₂CH₂CH₂CH₂CH₂CH₂)Si(CH₃)O][HSiCH₃O]ₚ₁₉Si(C H₃)₂H,

H(CH₃)₂SiO[(C₂H₅OSi(CH₃)₂CH₂CH₂CH₂CH₂CH₂CH₂CH₂CH₂)Si(CH₃)O][HSiCH₃O ]ₚ₂₀Si(CH₃)₂H,

H(CH₃)₂SiO[(C₂H₅OSi(CH₃)₂CH₂CH₂CH₂CH₂CH₂CH₂CH₂CH₂CH₂CH₂)Si(CH₃)O][H SiCH₃O]ₚ₂₁Si(CH₃)₂H,

H(CH₃)₂SiO[(Si(OCH₃)₃CH₂CH₂C₆H₄CH₂CH₂)Si(CH₃)O][HSiCH₃O]ₚ₂₂Si(CH₃)₂H,

H(CH₃)₂SiO[(Si(OCH₃)₃CH₂C₆H₄CH₂CH₂CH₂)Si(CH₃)O][HSiCH₃O]ₚ₂₃Si(CH₃)₂H,

H(CH₃)₂SiO[(Si(OCH₃)₃CH₂C₆H₄CH₂CH₂)Si(CH₃)O][HSiCH₃O]ₚ₂₄Si(CH₃)₂H,

H(CH₃)₂SiO[(Si(OCH₃)₃C₆H₄CH₂CH₂)Si(CH₃)O][HSiCH₃O]ₚ₂₅Si(CH₃)₂H,

H(CH₃)₂SiO[(Si(OCH₃)₃CH₂CH₂CH₂)Si(CH₃)O][HSiCH₃₀]ₚ₂₆Si(CH₃)₂H,

H(CH₃)₂SiO[(Si(OCH₃)₃CH₂CH₂CH₂CH₂)Si(CH₃)O][HSiCH₃O]ₚ₂₇Si(CH₃)₂H,

H(CH₃)₂SiO[(Si(OCH₃)₃CH₂CH₂CH₂CH₂CH₂CH₂)Si(CH₃)O][HSiCH₃O]ₚ₂₈Si(CH₃)₂H,

H(CH₃)₂SiO[(Si(OCH₃)₃CH₂CH₂CH₂CH₂CH₂CH₂CH₂CH₂)Si(CH₃)O][HSiCH₃O]ₚ₂₉Si (CH₃)₂H,

H(CH₃)₂SiO[(Si(OCH₃)₃CH₂CH₂CH₂CH₂CH₂CH₂CH₂CH₂CH₂CH₂)Si(CH₃)O][HSiC H₃O]ₚ₃₀Si(CH₃)₂H,

H(CH₃)₂SiO[(Si(OCH₃)₃CH₂CH₂C₆H₄CH₂CH₂)Si(CH₃)O][HSiCH₃₀]ₚ₃₁Si(CH₃)₂H,

H(CH₃)₂SiO[(Si(OCH₃)₃CH₂C₆H₄CH₂CH₂CH₂)Si(CH₃)O][HSiCH₃O]ₚ₃₂Si(CH₃)₂H,

H(CH₃)₂SiO[(Si(OCH₃)₃CH₂C₆H₄CH₂CH₂)Si(CH₃)O][HSiCH₃O]ₚ₃₃Si(CH₃)₂H,

H(CH₃)₂SiO[(Si(OCH₃)₃C₆H₄CH₂CH₂)Si(CH₃)O][HSiCH₃O]ₚ₃₄Si(CH₃)₂H,

H(CH₃)₂SiO[(Si(OCH₃)₃CH₂CH₂C₆H₄CH₂CH₂)Si(CH₃)O][HSiCH₃O]ₚ₃₅Si(CH₃)₂H,

H(CH₃)₂SiO[(CH₃O)Si(CH₃)CH₂CH₂CH₂CH₂CH₂CH₂Si(CH₃)₂OSiC₆H₅O]ₚ₃₆[HSi(CH ₃)₂OSiC₆H₅O]_{q4}Si(CH₃)₂H,

H(CH₃)₂SiO[Si(OCH₃)₂CH₂CH₂CH₂CH₂CH₂CH₂Si(CH₃)₂OSiC₆H₅O]ₚ₃₇[HSi(CH₃)₂O SiC₆H₅O]_{q5}Si(CH₃)₂H,

C₂H₅O(CH₃)₂SiO[SiH(CH₃)O]ₚ₃₈[SiCH₃(C₆H₅)O]_{q6}Si(CH₃)₂H,

Si(OC₂H₅)₃CH₂CH₂CH₂CH₂CH₂CH₂(CH₃)₂SiO[SiH(CH₃)O]ₚ₃₉[SiCH₃(C₆H₅)O]_{q7}Si(C H₃)₂H,

C₂H₅OSi(CH₃)₂CH₂CH₂CH₂CH₂CH₂CH₂(CH₃)₂SiO[SiH(CH₃)O]ₚ₄₀[SiCH₃(C₆H₅)O]_{q8} Si(CH₃)₂H,

H(CH₃)₂SiO(C₂H₅O)Si(CH₃)O[SiH(CH₃)O]ₚ₄₁[SiCH₃(C₆H₅)O]_{q9}Si(CH₃)₂H,

H(CH₃)₂SiO[Si(OC₂H₅)₃CH₂CH₂CH₂Si(CH₃)]O[SiH(CH₃)O]ₚ₄₂[SiCH₃(C₆H₅)O]_{q10}Si( CH₃)₂H. In these groups, p1 to p42 and q1 to q10 are numbers from 1 to 100. 1 to 99 hydrosilyl groups are preferably included in one molecule.

Examples of the alkoxy group-containing and amino group-free silane coupling agent include a hydrosilyl group-containing alkoxysilyl compound such as

(C₂H₅O)₃SiCH₂CH=CH₂,

(CH₃O)₃SiCH₂CH₂CH=CH₂,

(C₂H₅O)₃SiCH₂CH₂CH=CH₂,

(CH₃O)₃SiCH₂CH₂CH₂CH₂CH=CH₂,

(C₂H₅O)₃SiCH₂CH₂CH₂CH₂CH=CH₂,

(C₂H₅O)₃SiCH₂CH₂CH₂CH₂CH₂CH₂CH=CH₂,

(CH₃O)₃SiCH₂(CH₂)₇CH=CH₂,

(C₂H₅O)₂Si(CH=CH₂)OSi(OC₂H₅)CH=CH₂,

(CH₃O)₃SiCH₂CH₂C₆H₄CH=CH₂,

(CH₃O)₂Si(CH=CH₂)O[SiOCH₃(CH=CH₂)O]ₜ₁Si(OCH₃)₂CH=CH₂, (C₂H₅O)₂Si(CH=CH₂)O[SiOC₂H₅(CH=CH₂)O]ₜ₂Si(OC₂H₅)₃,

(C₂H₅O)₃SiCH₂CH₂CH₂Si(CH₃)₂OSi(CH₃)₂CH₂CH₂[Si(CH₃)₂O]ₜ₃CH=CH₂,

(CH₃O)₃SiCH₂CH₂CH₂Si(CH₃)₂OSi(CH₃)₂CH₂CH₂[Si(CH₃)₂O]ₜ₄CH=CH₂,

CH₃O(CH₃)₂SiCH₂CH₂CH₂Si(CH₃)₂OSi(CH₃)₂CH₂CH₂[Si(CH₃)₂O]ₜ₅CH=CH₂,

(C₂H₅O)₂CH₃SiCH₂CH₂CH₂Si(CH₃)₂OSi(CH₃)₂CH₂CH₂[Si(CH₃)₂O]ₜ₆CH=CH₂,

(C₂H₅O)₃SiCH₂CH₂CH₂Si(CH₃)₂OSi(CH₃)₂CH₂CH₂[Si(CH₃)₂O]ₜ₇CH=CH₂,

(C₂H₅O)₃SiCH₂CH₂CH₂Si(CH₃)₂OSi(CH₃)₂CH₂CH₂(Si(CH₃)₃O)Si(CH₃)O[SiCH₃(-)O] ᵤ₁Si(CH₃)₃CH=CH₂,

(C₂H₅O)₃SiCH₂CH₂CH₂Si(CH₃)₂OSi(CH₃)₂CH₂CH₂(Si(CH₃)₃O)Si(CH₃)O[SiCH₃(-)O] ᵤ₂[Si(CH₃)₂O]ₜ₈Si(CH₃)₃CH=CH₂,

(C₂H₅O)₂Si(CH=CH₂)O[SiCH₃(OC₂H₅)O]ᵤ₃Si(OC₂H₅)₂CH=CH₂,

(C₂H₅O)₂Si(CH=CH₂)O[Si(OC₂H₅)₂O]ᵤ₄Si(OC₂H₅)₂CH=CH₂,

(C₂H₅O)₂Si(CH=CH₂)O[Si(OC₂H₅)₂O]ᵤ₅Si(OC₂H₅)₂CH=CH₂. In these groups, t1 to t8 and u1 to u5 are numbers from 1 to 30. 1 to 30 vinyl groups are preferably included in one molecule.

The reaction of these vinyl group and SiH group may be promoted with a metal catalyst such as a platinum-containing compound to join the base material sheet and the elastomer sheet.

The alkoxy group-containing and amino group-free silane coupling agent may be an alkoxysilyl compound containing alkoxysilyl groups at both ends such as

(C₂H₅O)₃SiCH₂CH₂Si(OC₂H₅)₃,

(C₂H₅O)₂CH₃SiCH₂CH₂Si(OC₂H₅)₃,

(C₂H₅O)₃SiCH=CHSi(OC₂H₅)₃,

(CH₃O)₃SiCH₂CH₂Si(OCH₃)₃(CH₃O)₃SiCH₂CH₂C₆H₄CH₂CH₂Si(OCH₃)₃,

(CH₃O)₃Si[CH₂CH₂]₃Si(OCH₃)₃,

(CH₃O)₂Si[CH₂CH₂]₄Si(OCH₃)₃,

(C₂H₅O)₂Si(OC₂H₅)₂,

(CH₃O)₂CH₃SiCH₂CH₂Si(OCH₃)₂CH₃,

(C₂H₅O)₂CH₃SiOSi(OC₂H₅)₂CH₃,

(CH₃O)₃SiO[Si(OCH₃)₂O]ᵥ₁Si(OCH₃)₃,

(C₂H₅O)₃SiO[Si(OC₂H₅)₂O]ᵥ₂Si(OC₂H₅)₃,

(C₃H₇O)₃SiO[Si(OC₃H₇)₂O]ᵥ₃Si(OC₃H₇)₃. In these groups, v1 to v3 are numbers from 0 to 30.

The alkoxy group-containing and amino group-free silane coupling agent may be a hydrolytic group and silyl group-containing alkoxysilyl compound such as easily hydrolyzable organosilane below:

CH₃Si(OCOCH₃)₃,(CH₃)₂Si(OCOCH₃)₂,n-C₃H₇Si(OCOCH₃)₃,

CH₂=CHCH₂Si(OCOCH₃)₃, C₆H₅Si(OCOCH₃)₃, CF₃CF₂CH₂CH₂Si(OCOCH₃)₃,

CH₂=CHCH₂Si(OCOCH₃)₃, CH₃OSi(OCOCH₃)₃, C₂H₅OSi(OCOCH₃)₃,

CH₃Si(OCOC₃H₇)₃, CH₃Si[OC(CH₃)=CH₂]₃, (CH₃)₂Si[OC(CH₃)=CH₂]₃,

n-C₃H₇Si[OC(CH₃)=CH₂]₃, CH₂=CHCH₂Si[OC(CH₃)=CH₂]₃,

C₆H₅Si[OC(CH₃)=CH₂]₃, CF₃CF₂CH₂CH₂Si[OC(CH₃)=CH₂]₃,

CH₂=CHCH₂Si[OC(CH₃)=CH₂]₃, CH₃OSi[OC(CH₃)=CH₂]₃,

C₂H₅OSi[OC(CH₃)=CH₂]₃, CH₃Si[ON=C(CH₃)C₂H₅]₃, (CH₃)₂Si[ON=C(CH₃)C₂H₅]₂,

n-C₃H₇Si[ON=C(CH₃)C₂H₅]₃, CH₂=CHCH₂Si[ON=C(CH₃)C₂H₅]₃,

C₆H₅Si[ON=C(CH₃)C₂H₅]₃, CF₃CF₂CH₂CH₂Si[ON=C(CH₃)C₂H₅]₃,

CH₂=CHCH₂Si[ON=C(CH₃)C₂H₅]₃, CH₃OSi[ON=C(CH₃)C₂H₅]₃,

C₂H₅OSi[ON=C(CH₃)C₂H₅]]₃, CH₃Si[ON=C(CH₃)C₂H₅]₃, CH₃Si[N(CH₃)]₃,

(CH₃)₂Si[N(CH₃)]₂, n-C₃H₇Si[N(CH₃)]₃, CH₂=CHCH₂Si[N(CH₃)]₃, C₆H₅Si[N(CH₃)]₃,

CF₃CF₂CH₂CH₂Si[N(CH₃)]₃, CH₂=CHCH₂Si[N(CH₃)]₃, CH₃OSi[N(CH₃)]₃,

C₂H₅OSi[N(CH₃)]₃, CH₃Si[N(CH₃)]₃.

Examples of the alkoxy group and amino group-containing silane coupling agent include commercially available silane coupling agents, and specific examples include: amino group-containing alkoxysilyl compounds exemplified by N-2-(aminoethyl)-3-aminopropylmethyldimethoxysilane (KBM-602), N-2-(aminoethyl)-3-aminopropyltrimethoxysilane (KBM-603), N-2-(aminoethyl)-3-aminopropyltriethoxysilane (KBE-603), 3-aminopropyltrimethoxysilane (KBM-903), 3-aminopropyltriethoxysilane (KBE-903), 3-triethoxysilyl-N-(1,3-dimethyl-butylidene) propylamine (KBE-9103), N-phenyl-3-aminopropyltrimethoxysilane (KBM-573) and hydrochloride of N-(vinylbenzyl)-2-aminoethyl-3-aminopropyltrimethoxysilane (KBM-575) (all the silane coupling agents described above are made by Shin-Etsu Chemical Co., Ltd.; product names); and amino group-containing alkoxysilyl compounds exemplified by 3-aminopropyltrimethoxysilane (Z-6610), 3-aminopropyltrimethoxysilane (Z-6611), 3-(2-aminoethyl) aminopropyltrimethoxysilane (Z-6094), 3-phenylaminopropyltrimethoxysilane (Z-6883) and hydrochloride of N-[3-(trimethoxysilyl)propyl]-N'-[(ethenylphenyl)methyl-1,2-ethanediamine (Z-6032) (all the silane coupling agents described above are made by Dow Toray Co., Ltd.; product names).

Only one of the dry treatment and the molecular adhesive treatment may be performed or they may be performed alternately and continuously. For example, the joining may be performed only by the dry treatment, the joining may be performed by the molecular adhesive treatment following the dry treatment or the joining may be performed by the molecular adhesive treatment following the dry treatment and further the dry treatment. The joining may be performed only by the molecular adhesive treatment, the joining may be performed by the dry treatment following the molecular adhesive treatment or the joining may be performed by the dry treatment following the molecular adhesive treatment and further the molecular adhesive treatment.

As described above, in the thermoelectric conversion module 12 shown in Fig. 1(b), the constituent semiconductor elements of the thermoelectric conversion element 18 and the thermally conductive elastomer sheets 20, 20 are integrally joined by a direct covalent bond or an indirect covalent bond through the molecular adhesive, with the result that both of them can be sufficiently joined. Furthermore, the thermally conductive elastomer sheets 20, 20 of the thermoelectric conversion module 12 have rubber elasticity and are soft to be able to be in direct contact with the corresponding surfaces of the heat transfer target members 14 and 16. As described above, even if the constituent members of the thermoelectric conversion structure 10 shown in Fig. 1 are thermally deformed by thermal expansion or the like, the thermal deformation can be absorbed by the thermally conductive elastomer sheets 20, 20, with the result that it is possible to remove the possibility of separation between the constituent members and the thermally conductive elastomer sheets 20, 20. Moreover, the heat transfer characteristics of the thermally conductive elastomer sheets 20, 20 are enhanced, and thus thermal diffusivity is satisfactory, with the result that the heat transfer characteristics of the thermoelectric conversion element 18 and the heat transfer target members 14 and 16 can be enhanced. As described above, the constituent semiconductor elements and the thermally conductive elastomer sheets 20, 20 can be joined, and the thermally conductive elastomer sheets 20, 20 and the heat transfer target members 14 and 16 can be in intimate contact with each other without the formation of the thermally conductive grease layer, with the result that the productivity of the thermoelectric conversion structure 10 can be enhanced. The thermoelectric conversion structure 10 can also be applied to an application for removing the thermoelectric conversion module 12 from the heat transfer target members 14 and 16 or to a human body.

### Embodiments

Although examples of the present invention will be described in detail below, the scope of the present invention is not limited to these examples.

### Example 1

Experiments were performed on the generation of electricity by the Seebeck effect in the thermoelectric conversion module 12 of the thermoelectric conversion structure 10.

### (Production of thermally conductive elastomer-type thermoelectric conversion module 12)

Molecular adhesive treatment was performed on a thermoelectric conversion element (bismuth-telluride semiconductor element, p-n number: 73 couples). The molecular adhesive treatment was performed with an ethanol solution of vinyl triethoxysilane (made by Shin-Etsu Chemical Co., Ltd., product name: KBE-1003) used as a molecular adhesive, and thereafter drying was performed at 80°C for 30 minutes. Then, dry treatment was performed on a thermally conductive elastomer sheet. For the thermally conductive elastomer sheet, as thermally conductive fillers, magnesium oxide (MgO) and aluminum oxide (Al₂O₃) were dispersed in dimethyl silicone rubber, the thermally conductive elastomer sheet was thereafter put into a 150 × 150 × 0.5 mm mold for a sheet and was cured at 150°C for 10 minutes with a 75t pressure heating press, with the result that the thermally conductive elastomer sheet (thermal conductivity: 3 W/(m·K), hardness: A82/s) having a thickness of 0.5 mm was obtained. The thermally conductive elastomer sheet obtained was cut into 50 × 50 mm, dry treatment was performed with an atmospheric pressure corona surface improvement device (made by Shinko Electric & Instrumentation Co., Ltd., product name: corona master) under conditions of power supply: AC100 V, gap length: 0.5 mm, output voltage: 18.0 kV (surface voltage), power: 18 W, oscillation frequency: 20 kHz, temperature: 20°C, movement speed: 70 mm/sec and number of movements: three times, and thus the thermally conductive elastomer sheet subjected to the dry treatment was obtained. Two thermally conductive elastomer sheets obtained and subjected to the dry treatment were prepared, the thermoelectric conversion element was sandwiched vertically and was pressurized and heated at 80°C for 30 minutes with a thermocompression press and the thermally conductive elastomer sheets were adhered to the thermoelectric conversion element 18, with the result that a thermally conductive elastomer-type thermoelectric conversion module was obtained. The hardness "A" of the thermally conductive elastomer sheet indicates that measurements were performed with a type A durometer according to JIS K 6253.

### (Production of ceramic-type thermoelectric conversion module 12)

Then, as a comparative example, a general combination of ceramic and a thermoelectric conversion element was used to produce a ceramic-type thermoelectric conversion module. As the thermoelectric conversion element, the same thermoelectric conversion element as in the thermally conductive elastomer type was used. As the ceramic, a 50 × 50 mm aluminum oxide plate having a thickness of 0.5 mm (thermal conductivity: 30 W/(m·K)) was used. Two ceramic plates were prepared, the thermoelectric conversion element was sandwiched vertically and the ceramic and the thermoelectric conversion element were adhered with an inorganic heat-resistant adhesive (made by 3M Company, product number: TB3732), with the result that a ceramic-type thermoelectric conversion module was obtained.

### (Production of thermoelectric conversion structure for Seebeck effect)

### (1) Thermally conductive elastomer-type (without grease) thermoelectric conversion structure 10

In the produced thermoelectric conversion module 12, as shown in Fig. 2(a), on the thermally conductive elastomer sheet 20 joined on the heating side of the thermoelectric conversion element 18, a heating portion 26 serving as a heat transfer target member 16 was mounted. The heating portion 26 was formed with a copper plate 26a, a heating Peltier device 26b and a heat sink 26c, and the copper plate 26a and the thermally conductive elastomer sheet 20 on the heating side were in direct contact with each other. The temperature of the copper plate 26a was detected with a temperature sensor 26d provided at an end of the copper plate 16a, and the Peltier device 26b for heating was controlled such that the temperature was constant. A cooling portion 24 serving as a heat transfer target member 14 was in direct contact with the thermally conductive elastomer sheet 20 on the cooling side of the thermoelectric conversion module 12. The copper plate 16a of the thermoelectric conversion structure 10 was controlled to have a temperature of 50°C, and the cooling portion 24 was controlled with a colling Peltier device to have a temperature of 10°C. Hence, a temperature difference between the heating portion 26 and the cooling portion 24 was 40°C.

### (2) Thermally conductive elastomer-type (with grease) thermoelectric conversion structure

A thermally conductive elastomer-type (with grease) thermoelectric conversion structure had the same configuration as the thermally conductive elastomer-type (without grease) thermoelectric conversion structure except that in the thermally conductive elastomer-type (with grease) thermoelectric conversion structure 10, a silicone heat dissipation grease (made by SHENZHEN HALNZIYE ELECTRONIC COMPANY, product number: HY-880, thermal conductivity of 5W/mK) was applied to the surface of the copper plate 26a and the thermally conductive elastomer sheet 20 on the heating side and the surface of the thermally conductive elastomer sheet 20 on the colling side and the cooling portion 24 to form a thermally conductive grease layer.

### (3) Ceramic-type (without grease) thermoelectric conversion structure

A ceramic-type (without grease) thermoelectric conversion structure had the same configuration as the thermally conductive elastomer-type (without grease) thermoelectric conversion structure except that the thermally conductive elastomer-type (without grease) thermoelectric conversion structure 10 was changed from the thermally conductive elastomer type to the ceramic type.

### (4) Ceramic-type (with grease) thermoelectric conversion structure

A ceramic-type (with grease) thermoelectric conversion structure had the same configuration as the thermally conductive elastomer-type (without grease) thermoelectric conversion structure except that in the ceramic-type (without grease) thermoelectric conversion structure 10, the silicone heat dissipation grease was applied to the surface of the copper plate 26a and the ceramic on the heating side and the surface of the ceramic on the colling side and the cooling portion 24 to form a thermally conductive grease layer.

### (Measurement of peak power)

The peak power of the thermoelectric conversion element of each of the thermoelectric conversion structures was measured with a circuit shown in Fig. 2(b). A predetermined electronic load (resistance) was applied to a current circuit from the thermoelectric conversion element of the thermoelectric conversion module 12 shown in Fig. 2(a), and thus a voltage which was generated was measured with a voltmeter, with the result that power was calculated. The electronic load (resistance) was changed, and thus the peak power was determined from a graph of the electronic load and the power shown in Fig. 2(c). The peak power of each of the thermoelectric conversion structures was shown in Fig. 3.

As is clear from Fig. 3, the thermally conductive elastomer-type (without grease) thermoelectric conversion structure 10 showed a higher peak power than the ceramic-type (without grease) thermoelectric conversion structure, and the peak power was substantially equal to the peak power of each of the thermally conductive elastomer-type (with grease) thermoelectric conversion structure and the ceramic-type (with grease) thermoelectric conversion structure. Hence, it is indicated that the surfaces of the thermally conductive elastomer sheets 20, 20 of the thermally conductive elastomer-type (without grease) thermoelectric conversion structure 10 and the corresponding surfaces of the cooling portion 24 and the heating portion 26 were in direct intimate contact with each other so as to have sufficient thermal conductivity without the formation of a thermally conductive grease layer.

### Example 2

Experiments were performed on cooling achieved by the Peltier effect in the thermoelectric conversion module 12 of the thermoelectric conversion structure 10.

### (Production of thermoelectric conversion structure for Peltier effect)

### (1) Conductive rubber-type (without grease) thermoelectric conversion structure 10

In the thermally conductive elastomer-type (without grease) thermoelectric conversion structure 10, as shown in Fig. 4(a), the copper plate 26a was in direct intimate contact with the thermally conductive elastomer sheet 20 on the cooling side of the thermoelectric conversion module 12 produced in example 1. A weight 32 of 155 g was placed on a stage 30 arranged on the copper plate 26a, and the temperature of the copper plate 26a was detected with a temperature sensor 34. As shown in Fig. 4(a), the cooling portion 24 which was cooled with the cooling Peltier device was in direct intimate contact with the thermally conductive elastomer sheet 20 on the heating side of the thermoelectric conversion module 12.

### (2) Thermally conductive elastomer-type (with grease) thermoelectric conversion structure

A thermally conductive elastomer-type (with grease) thermoelectric conversion structure had the same configuration as the thermally conductive elastomer-type (without grease) thermoelectric conversion structure except that in a conductive rubber-type (with grease) thermoelectric conversion structure 10, the silicone heat dissipation grease (thermal conductivity of 5W/mK) was applied to the surface of the copper plate 26a and the thermally conductive elastomer sheet 20 on the cooling side and the surface of the thermally conductive elastomer sheet 20 on the heating side and the cooling portion 24 to form a thermally conductive grease layer.

### (3) Ceramic-type (without grease) thermoelectric conversion structure

A ceramic-type (without grease) thermoelectric conversion structure had the same configuration as the thermally conductive elastomer-type (without grease) thermoelectric conversion structure except that the thermally conductive elastomer-type (without grease) thermoelectric conversion structure 10 was changed from the thermally conductive elastomer type to the ceramic type.

### (4) Ceramic-type (with grease) thermoelectric conversion structure

A ceramic-type (with grease) thermoelectric conversion structure had the same configuration as the thermally conductive elastomer-type (without grease) thermoelectric conversion structure except that in the ceramic-type (without grease) thermoelectric conversion structure 10, the silicone heat dissipation grease was applied to the surface of the copper plate 26a and the ceramic on the heating side and the surface of the ceramic on the colling side and the cooling portion 24 to form a thermally conductive grease layer.

### (Measurement of minimum reached temperature of copper plate 26a)

A predetermined drive current was supplied to the thermoelectric conversion module 12, and the temperature of the copper plate 26a was detected with the temperature sensor 34. The temperature of the copper plate 26a five minutes after the start of the supply of the drive current to the thermoelectric conversion module 12 was assumed to be the minimum reached temperature. The value of the drive current supplied to the thermoelectric conversion module 12 was changed, the minimum reached temperature of each of the thermoelectric conversion elements was measured and the results thereof are shown in Fig. 4(b).

As is clear from Fig. 4(b), the thermally conductive elastomer-type (without grease) thermoelectric conversion structure 10 was lower in the minimum reached temperature than the ceramic-type (without grease) thermoelectric conversion structure, and the heat transfer of the thermoelectric conversion module 12 and the copper plate 26a and the cooling portion 24 serving as the heat transfer target members was satisfactory. When the drive current was 3 A, the minimum reached temperature of the ceramic-type (without grease) thermoelectric conversion structure was higher than the minimum reached temperature when the drive current was 1 or 2 A. It is estimated that this phenomenon resulted from the fact that the heat transfer of the ceramic plate of the thermoelectric conversion structure and the copper plate 26a and the cooling portion 24 was insufficient and thus heat accumulated in the thermoelectric conversion module.

The minimum reached temperature of the thermally conductive elastomer-type (without grease) thermoelectric conversion structure 10 was equal to the minimum reached temperature of the thermally conductive elastomer-type (with grease) thermoelectric conversion structure. Hence, the thermoelectric conversion module 12 was used, and thus even when the thermally conductive grease layer was not formed, the heat transfer characteristics of the thermoelectric conversion module 12 and the copper plate 26a and the cooling portion 24 serving as the heat transfer target members were the same as the heat transfer characteristics when the thermally conductive grease layer was formed.

In Fig. 4(b), the minimum reached temperature of the ceramic-type (with grease) thermoelectric conversion structure was lower than the minimum reached temperature of each of the thermally conductive elastomer-type (without grease) thermoelectric conversion structure 10 and the thermally conductive elastomer-type (with grease) thermoelectric conversion structure. It is estimated that this resulted from the fact that the ceramic plate used in the ceramic-type thermoelectric conversion module was significantly greater in specific heat than the thermally conductive elastomer sheet 20 used in the thermally conductive elastomer-type thermoelectric conversion module so as to have a large heat capacity. Hence, the minimum reached temperature of the ceramic-type (with grease) thermoelectric conversion structure was only about 4°C lower than the minimum reached temperatures of the thermally conductive elastomer-type (without grease) thermoelectric conversion structure 10 and the thermally conductive elastomer-type (with grease) thermoelectric conversion structure, and thus it is indicated that even in the ceramic-type (with grease) thermoelectric conversion structure, the heat transfer of the ceramic plate and the copper plate 26a and the cooling portion 24 was not sufficient.

### Example 3

Experiments were performed on the influence of the hardness of the elastomer sheet of the thermoelectric conversion structure 10 using the generation of electricity by the Seebeck effect in the thermoelectric conversion module 12 of the thermoelectric conversion structure 10. Since in the thermally conductive elastomer sheet 20, not only the thermal conductivity but also the hardness was changed by addition of the thermally conductive filler, a silicone elastomer sheet was used instead of the thermally conductive elastomer sheet 20, and thus the experiments were performed.

### (Production of silicone elastomer sheets having different hardnesses)

For the silicone elastomer sheet, dimethyl silicone rubber was put into a 150 × 150 × 0.5 mm mold for a sheet and was cured at 150°C for 10 minutes with a 75t pressure heating press, with the result that a silicone sheet having a thickness of 0.5 mm was obtained. As the dimethyl silicone rubbers used, RBB-6670 (hardness: A70/s), was used in accordance with the claimed invention and for comparison, RBB-6650 (hardness: A50/s) and RBB-6630 (hardness: A30/s) (all the dimethyl silicone rubbers described above were made by Dow Toray Co., Ltd., thermal conductivity of 0.2 W/(m·K)) were used. The hardnesses were measured with a type A durometer according to JIS K 6253.

### (Production of thermoelectric conversion structure for Seebeck effect)

### (1) Thermoelectric conversion structure of thermoelectric conversion module (without grease) whose elastomer sheet had different hardness

The thermoelectric conversion structure of the thermoelectric conversion module (without grease) whose elastomer sheet had a different hardness had the same configuration as the thermally conductive elastomer-type (without grease) thermoelectric conversion structure 10 except that, instead of the thermally conductive elastomer sheet 20 of the thermally conductive elastomer-type (without grease) thermoelectric conversion structure 10, the silicone elastomer sheet having a different hardness was used.

### (2) Thermoelectric conversion structure of thermoelectric conversion module (with grease) whose elastomer sheet had different hardness

The thermoelectric conversion structure of the thermoelectric conversion module (with grease) whose elastomer sheet had a different hardness had the same configuration as the thermally conductive elastomer-type (with grease) thermoelectric conversion structure 10 except that, instead of the thermally conductive elastomer sheet 20 of the thermally conductive elastomer-type (with grease) thermoelectric conversion structure 10, the silicone elastomer sheet having a different hardness was used.

### (Measurement of peak power)

The peak power of the thermoelectric conversion element of each of the thermoelectric conversion structures whose elastomer sheets had different hardnesses was measured with the circuit shown in Fig. 2(b). The predetermined electronic load (resistance) was applied to the current circuit from the thermoelectric conversion element of the thermoelectric conversion module 12 shown in Fig. 2(a), and thus the voltage which was generated was measured with the voltmeter, with the result that power was calculated. The electronic load (resistance) was changed, and thus the peak power was determined from the graph of the electronic load and the power shown in Fig. 2(c). The peak power of each of the thermoelectric conversion structures was shown in Fig. 5.

The peak power of the thermoelectric conversion structure shown in Fig. 5 was lower than the peak power of the thermoelectric conversion structure using the thermally conductive elastomer sheet 20 shown in Fig. 3 because the silicone elastomer sheet was used as the elastomer sheet instead of the thermally conductive elastomer sheet 20. However, as is clear from Fig. 5, even in any of the thermoelectric conversion structures using the silicone elastomer sheets having different hardnesses, the thermoelectric conversion structure with grease and the thermoelectric conversion structure without grease were substantially equal in peak power to each other. As described above, it is indicated that the surfaces of the silicone elastomer sheets of the thermoelectric conversion structure 10 and the corresponding surfaces of the cooling portion 24 and the heating portion 26 were in direct intimate contact with each other so as to have sufficient thermal conductivity without the formation of a thermally conductive grease layer. The peak power of the thermoelectric conversion structure in Fig. 5 tended to be lowered as the hardness of the silicone elastomer sheet was lowered. However, it is estimated that since the hardness of the silicone elastomer sheet was adjusted by the mixed amount of silica serving as a thermal conductor, in the silicone elastomer sheet having a small amount of silica mixed to have a low hardness, as compared with the silicone elastomer sheet having a large amount of silica mixed to have a high hardness, the thermal conductivity was lowered.

### Example 4

Experiments were performed on the influence of the thermal conductivity of the thermally conductive elastomer sheet 20 of the thermoelectric conversion structure 10 using the generation of electricity by the Seebeck effect in the thermoelectric conversion module 12 of the thermoelectric conversion structure 10.

### (Production of thermoelectric conversion module 12 in which thermally conductive elastomer sheet 20 had different thermal conductivity)

A thermoelectric conversion module was produced in the same manner as the thermally conductive elastomer-type thermoelectric conversion module 12 except that as the thermally conductive elastomer sheet 20 of the thermally conductive elastomer-type thermoelectric conversion module 12, a thermally conductive elastomer sheet having a different thermal conductivity was used. For the thermally conductive elastomer sheet, as thermally conductive fillers, magnesium oxide (MgO) and aluminum oxide (Al₂O₃) were dispersed in dimethyl silicone rubber so as to achieve a predetermined thermal conductivity, the thermally conductive elastomer sheet was thereafter put into a 150 × 150 × 0.5 mm mold for a sheet and was cured at 150°C for 10 minutes with a 75t pressure heating press, with the result that the thermally conductive elastomer sheet having a thickness of 0.5 mm was obtained. Three types of thermally conductive elastomer sheets having a thermal conductivity of 5.0 W/(m·K) (hardness: A80/s), a thermal conductivity of 3.0 W/(m·K) (hardness: A83/s) and a thermal conductivity of 0.2 W/(m·K) (hardness: A70/s) were compared.

### (Measurement of peak power)

The peak power of the thermoelectric conversion element of each of the thermoelectric conversion structures using thermally conductive elastomer sheets having different thermal conductivities was measured with the circuit shown in Fig. 2(b). The predetermined electronic load (resistance) was applied to the current circuit from the thermoelectric conversion element of the thermoelectric conversion module 12 shown in Fig. 2(a), and thus the voltage which was generated was measured with the voltmeter, with the result that power was calculated. The electronic load (resistance) was changed, and thus the peak power was determined from the graph of the electronic load and the power shown in Fig. 2(c). The peak power of each of the thermoelectric conversion structures was shown in Fig. 6.

As is clear from Fig. 6, as the thermal conductivity of the thermally conductive elastomer sheet was increased, the peak amount of electricity generated in the thermoelectric conversion structure was increased. In particular, the peak amounts of electricity generated in the thermoelectric conversion structures using the thermally conductive elastomer sheets having a thermal conductivity of 5.0 W/(m·K) and a thermal conductivity of 3.0 W/(m·K) were significantly increased as compared with the peak amount of electricity generated in the thermoelectric conversion structure using the thermally conductive elastomer sheet having a thermal conductivity of 0.2 W/(m·K). Even in any of the thermoelectric conversion structures using the thermally conductive elastomer sheets having different thermal conductivities, the thermoelectric conversion structure with grease and the thermoelectric conversion structure without grease were substantially equal in peak power to each other. Hence, it is indicated that the surfaces of the thermoelectric conversion structure 10 and the corresponding surfaces of the cooling portion 24 and the heating portion 26 were in direct intimate contact with each other so as to have sufficient thermal conductivity without the formation of a thermally conductive grease layer.

### Industrial Applicability

In the thermoelectric conversion structure according to the present invention, satisfactory heat transfer characteristics are provided without the formation of a thermally conductive grease layer between the thermoelectric conversion module and the heat transfer target members, and thus the productivity of the thermoelectric conversion structure can be enhanced, and the thermoelectric conversion structure can be applied to an application for removing the thermoelectric conversion module from the heat transfer target members and to a human body.

### Explanations of Letters or Numerals

10: thermoelectric conversion structure, 12: thermoelectric conversion module, 14 and 16: heat transfer target members, 16a: copper plate, 18: thermoelectric conversion element, 18a: n-type semiconductor element, 18b: p-type semiconductor element, 18c: conductive pattern, 20: thermally conductive elastomer sheet, 24: cooling portion, 26: heating portion, 26a: copper plate, 26b: heating Peltier device, 26c: heat sink, 26d and 34: temperature sensors, 30: stage.

## Claims

1. A thermoelectric conversion structure (10)
in which a thermoelectric conversion module (12) integrated by joining surfaces of a thermoelectric conversion element (18)
on a high temperature side and a low temperature side to thermally conductive elastomer sheets (20,20)
containing a thermally conductive filler is arranged between heat transfer target members (14,16)
that transfer heat to the thermoelectric conversion element,
wherein surfaces of the thermally conductive elastomer sheets and corresponding surfaces of the heat transfer target members are in direct intimate contact with each other and are removable from each other, a thickness of each of the thermally conductive elastomer sheets is 0.3-0.5mm,
a hardness of the thermally conductive elastomer sheets measured with a type A durometer according to JIS K 6253 : 2012 at standard testing temperature thereof according to JIS K 6250 6.1: 2006 is 70/s-90/s,
and
elastomer components of the thermally conductive elastomer sheets are resin material selected from the group consisting of polyimide, PEEK and PSS, or rubber material selected from the group consisting of silicone rubber, ethylene-propylene-diene copolymer rubber and urethane rubber.

2. The thermoelectric conversion structure according to claim 1,
Wherein components of the thermally conductive elastomer sheets are peroxide cross-linking silicone rubber, additional cross-linking silicone rubber, condensation cross-linking silicone rubber or a blend of one of these silicone rubbers and olefin rubber.

3. The thermoelectric conversion structure according to claim 1 or 2,
wherein a thermal conductivity of the thermally conductive elastomer sheets
is 1.0 W/(m·K) to 10 W/(m·K).

4. The thermoelectric conversion structure according to any one of claims 1 to 3,
wherein the thermoelectric conversion element and the thermally conductive elastomer sheets are integrally joined by a direct covalent bond between active groups in the surfaces of the thermoelectric conversion element and the thermally conductive elastomer sheets or an indirect covalent bond therebetween through a molecular adhesive.

## Patentansprüche

1. Thermoelektrische Umwandlungsstruktur (10), in der ein thermoelektrisches Umwandlungsmodul (12), das durch Verbinden der Oberflächen eines thermoelektrischen Umwandlungselements (18) auf der Hochtemperaturseite und der Niedertemperaturseite mit wärmeleitfähigen Elastomerfolien (20, 20), die einen wärmeleitfähigen Füllstoff enthalten, integriert ist, zwischen den Wärmeübertragungszielelementen (14, 16), die Wärme an das thermoelektrische Umwandlungselement abgeben, angeordnet ist,
wobei die Oberflächen der wärmeleitfähigen Elastomerfolien und entsprechende Oberflächen der Wärmeübertragungszielelemente in direktem innigen Kontakt miteinander stehen und voneinander entfernt werden können,
die Dicke der wärmeleitfähigen Elastomerfolien jeweils 0,3 bis 0,5 mm beträgt,
die Härte der wärmeleitfähigen Elastomerfolien, die mit einem Typ-A-Durometer gemäß JIS K 6253 : 2012 bei dessen Standardprüftemperatur gemäß JIS K 6250 6.1: 2006 gemessen wird, 70/s bis 90/s beträgt
und
es sich bei den Elastomerkomponenten der wärmeleitfähigen Elastomerfolien um ein Harzmaterial, das aus der Gruppe ausgewählt ist, die aus Polyimid, PEEK und PSS besteht, oder um ein Kautschukmaterial, das aus der Gruppe ausgewählt ist, die aus Silikonkautschuk, Ethylen-Propylen-Dien-Copolymer-Kautschuk und Urethankautschuk besteht, handelt.

2. Thermoelektrische Umwandlungsstruktur gemäß Anspruch 1,
wobei die Komponenten der wärmeleitfähigen Elastomerfolien Peroxid-vulkanisierter Silikonkautschuk, additiv vulkanisierter Silikonkautschuk, kondensationsvulkanisierter Silikonkautschuk oder eine Mischung von einem dieser Silikonkautschuke mit Olefinkautschuk sind.

3. Thermoelektrische Umwandlungsstruktur gemäß Anspruch 1 oder 2,
wobei die Wärmeleitfähigkeit der wärmeleitfähigen Elastomerfolien 1,0 W/(m·K) bis 10 W/(m·K) beträgt.

4. Thermoelektrische Umwandlungsstruktur gemäß einem der Ansprüche 1 bis 3,
wobei das thermoelektrische Umwandlungselement und die wärmeleitfähigen Elastomerfolien durch eine direkte kovalente Bindung zwischen aktiven Gruppen in den Oberflächen des thermoelektrischen Umwandlungselements und der wärmeleitfähigen Elastomerfolien oder eine indirekte kovalente Bindung zwischen denselben durch einen molekularen Kleber integral miteinander verbunden sind.

## Revendications

1. Structure de conversion thermoélectrique (10), dans laquelle un module de conversion thermoélectrique (12) intégré en assemblant des surfaces d'un élément de conversion thermoélectrique (18) sur un côté de haute température et un côté de basse température avec des feuilles d'élastomère thermoconductrices (20, 20) contenant une charge thermoconductrice est arrangé entre des éléments cibles de transfert thermique (14, 16) qui transfèrent la chaleur à l'élément de conversion thermoélectrique,
dans laquelle des surfaces des feuilles d'élastomère thermoconductrices et des surfaces correspondantes des éléments cibles de transfert thermique sont en contact intime et direct les unes avec les autres, et sont amovibles les unes des autres,
l'épaisseur de chacune des feuilles d'élastomère thermoconductrices est de 0,3 à 0,5 mm,
la dureté des feuilles d'élastomère thermoconductrices, mesurée au moyen d'un duromètre de type A conformément à la norme JIS K 6253 : 2012 à la température d'essai standard définie par la norme JIS K 6250 6.1 : 2006, est comprise entre 70/s et 90/s,
et
les composants élastomères des feuilles d'élastomère thermoconductrices sont un matériau de résine choisi dans le groupe consistant en polyimide, PEEK et PSS, ou un matériau de caoutchouc choisi dans le groupe consistant en caoutchouc de silicone, caoutchouc copolymère éthylène-propylène-diène et caoutchouc d'uréthane.

2. Structure de conversion thermoélectrique selon la revendication 1,
dans laquelle les composants des feuilles d'élastomère thermoconductrices sont un caoutchouc de silicone réticulable par peroxyde, un caoutchouc de silicone réticulable par addition, un caoutchouc de silicone réticulable par condensation ou un mélange de l'un de ces caoutchoucs de silicone et d'un caoutchouc oléfinique.

3. Structure de conversion thermoélectrique selon la revendication 1 ou 2,
dans laquelle la conductivité thermique des feuilles d'élastomère thermoconductrices est de 1,0 W/(m·K) à 10 W/(m·K).

4. Structure de conversion thermoélectrique selon l'une quelconque des revendications 1 à 3,
dans laquelle ledit élément de conversion thermoélectrique et lesdites feuilles d'élastomère thermoconductrices sont assemblés intégralement par une liaison covalente directe entre des groupes actifs dans les surfaces dudit élément de conversion thermoélectrique et desdites feuilles d'élastomère thermoconductrices, ou par une liaison covalente indirecte à l'intermédiaire d'un adhésif moléculaire.
